## Europäisches Patentamt
## European Patent Office
## Office européen des brevets

(19)

(11) Veröffentlichungsnummer: **0 087 094**
**B1**

(12)

# EUROPÄISCHE PATENTSCHRIFT

(45) Veröffentlichungstag der Patentschrift:
**18.12.85**

(21) Anmeldenummer: **83101371.9**

(22) Anmeldetag: **12.02.83**

(51) Int. Cl.⁴: **G 01 R 31/28, G 08 B 29/00**

(54) **Schaltungsanordnung mit einem Schaltgerät und einem Fehlerindikator.**

(30) Priorität: **18.02.82 DE 3205737**

(43) Veröffentlichungstag der Anmeldung:
**31.08.83 Patentblatt 83/35**

(45) Bekanntmachung des Hinweises auf die Patenterteilung:
**18.12.85 Patentblatt 85/51**

(84) Benannte Vertragsstaaten:
**AT BE CH DE FR GB IT LI LU NL SE**

(56) Entgegenhaltungen:
**DE - A - 1 951 137**
**DE - A - 2 626 959**
**DE - B - 1 238 811**
**DE - B - 2 628 427**
**DE - C - 3 038 141**

(73) Patentinhaber: **I f m electronic gmbh, Teichstrasse 4,
D-4300 Essen 1 (DE)**

(72) Erfinder: **Buck, Robert, Am Kirchbühl 28,
D-7995 Neukirch (DE)**
Erfinder: **Marhofer, Gerd, Beckmannsbusch 67,
D-4300 Essen-Bredeney (DE)**
Erfinder: **Friedrich, Michael Burkhard, Rosenstrasse 10,
D-7993 Neukirch (DE)**
Erfinder: **Gesthuysen, Hans Dieter, Dipl.-Ing.,
Uhlandstrasse 3, D-4300 Essen-Kettwig (DE)**

(74) Vertreter: **Gesthuysen, Hans Dieter, Dipl.-Ing. et al,
Patentanwälte Gesthuysen + von Rohr
Huyssenallee 15 Postfach 10 13 33, D-4300 Essen 1 (DE)**

EP 0 087 094 B1

## Beschreibung

Die Erfindung betrifft eine Schaltungsanordnung mit einem elektronischen, vorzugsweise berührungslos arbeitenden Schaltgerät und einem an den Ausgang des elektronischen Schaltgerätes angeschlossenen Fehlerindikator, wobei das elektronische Schaltgerät einen von aussen beeinflussbaren Anwesenheitsindikator, z. B. einen Oszillator, und einen von dem Anwesenheitsindikator steuerbaren elektronischen Schalter, z.B. einen Transistor, einen Thyristor oder einen Triac, aufweist und mit Hilfe des Fehlerindikators feststellbar ist, ob das elektronische Schaltgerät und/oder ein an das elektronische Schaltgerät angeschlossener Aussenleiter einen Fehler aufweist, nämlich ein Überprüfungsimpulse abgebender — interner oder externer — Überprüfungsimpulsgenerator vorgesehen ist, das elektronische Schaltgerät dann, wenn es keine Fehler aufweist, an seinem Ausgang eine ununterbrochene Folge von Überwachungsimpulsen abgibt und der Fehlerindikator dann und nur dann ein Fehlersignal abgibt, wenn am Fehlerindikator keine ununterbrochene Folge von Überwachungsimpulsen ankommt.

Elektronische Schaltgeräte der Art, wie sie wesentlicher Bestandteil der in Rede stehenden Schaltungsanordnung sind, sind kontaktlos ausgeführt und werden in zunehmenden Masse anstelle von elektrischen, mechanisch betätigten Schaltgeräten, die kontaktbehaftet ausgeführt sind, in elektrischen Mess-, Steuer- und Regelkreisen verwendet. Das gilt insbesondere für sogenannte Annäherungsschalter, d.h. für elektronische Schaltgeräte, die berührungslos arbeiten. Mit solchen Annäherungsschaltern wird indiziert, ob sich ein Beeinflussungselement, für das der entsprechende Annäherungsschalter sensitiv ist, dem Annäherungsschalter hinreichend weit genähert hat. (Hat sich nämlich ein Beeinflussungselement, für das der entsprechende Annäherungsschalter sensitiv ist, dem Anwesenheitsindikator hinreichend weit genähert, so steuert der Anwesenheitsindikator den elektronischen Schalter um; d.h. bei einem als Schliesser ausgeführten Schaltgerät wird der nicht leitende elektronische Schalter nunmehr leitend, während bei einem als Öffner ausgeführtem Schaltgerät der leitende elektronische Schalter nunmehr sperrt.)

Wesentlicher Bestandteil von elektronischen Schaltgeräten der zuvor beschriebenen Art ist also u.a. der von aussen beeinflussbare Anwesenheitsindikator.

Als Anwesenheitsindikator kann z.B. ein induktiv oder kapazitiv beeinflussbarer Oszillator vorgesehen sein; es handelt sich dann um induktive oder kapazitive Annäherungsschalter (vgl. z.B. die deutschen Offenlegungsschriften bzw. Auslegeschriften bzw. Patentschriften 1 951 137, 1 966 178, 1 966 213, 2 036 840, 2 127 956, 2 203 038, 2 203 039, 2 203 040, 2 203 906, 2 330 233, 2 331 732, 2 356 490, 2 613 423, 2 616 265, 2 616 733, 2 628 427, 2 711 877 und 2 744 785). Als Anwesenheitsindikator kann z.B. ein Fotowiderstand, eine Fotodiode oder ein Fototransistor, vorgesehen sein; es handelt sich dann um optoelektronische Annäherungsschalter (vgl. z.B. die deutsche Offenlegungsschrift 2 824 582).

Bei induktiven Annäherungsschaltern gilt für den Oszillator, solange ein Metallteil einen vorgegebenen Abstand noch nicht erreicht hat, $K \cdot V = 1$ mit $K$ = Rückkopplungsfaktor und $V$ = Verstärkungsfaktor des Oszillators, d. h. der Oszillator schwingt. Erreicht das entsprechende Metallteil den vorgeschriebenen Anstand, so führt die zunehmende Bedämpfung des Oszillators zu einer Verringerung des Verstärkungsfaktors $V$, so dass $K \cdot V < 1$ wird, d.h. der Oszillator hört auf zu schwingen. Bei kapazitiven Annäherungsschaltern gilt für den Oszillator, solange ein Ansprechkörper die Kapazität zwischen einer Ansprechelektrode und einer Gegenelektrode noch nicht hinreichend vergrössert hat, also einen vorgegebenen Abstand noch nicht erreicht hat, $K \cdot V < 1$, d.h. der Oszillator schwingt nicht. Erreicht der Ansprechkörper den vorgegebenen Abstand, so führt die steigende Kapazität zwischen der Ansprechelektrode und der Gegenelektrode zu einer Vergrösserung des Rückkopplungsfaktors $K$, so dass $K \cdot V = 1$ wird, d.h. der Oszillator beginnt zu schwingen. Bei beiden Ausführungsformen wird abhängig von den unterschiedlichen Zuständen des Oszillators der elektronische Schalter, z.B. ein Transistor, ein Thyristor oder ein Triac, gesteuert.

Optoelektronische Annäherungsschalter weisen einen Lichtsender und einen Lichtempfänger auf und werden auch als Lichtschranken bezeichnet. Dabei unterscheidet man zwischen einem Lichtschrankentyp, bei dem der Lichtsender und der Lichtempfänger auf entgegengesetzten Seiten einer Überwachungsstrecke angeordnet sind, und einem Lichtschrankentyp, bei dem der Lichtsender und der Lichtempfänger am gleichen Ende einer Überwachungsstrecke angeordnet sind, während ein am anderen Ende der Überwachungsstrecke angeordneter Reflektor den vom Lichtsender ausgehenden Lichtstrahl zum Lichtempfänger zurück reflektiert. In beiden Fällen spricht der Anwesenheitsindikator an, wenn der normalerweise vom Lichtsender zum Lichtempfänger gelangende Lichtstrahl durch ein in die Überwachungsstrecke gelangtes Beeinflussungselement unterbrochen wird. Es gibt jedoch auch Lichtschranken des zuletzt beschriebenen Lichtschrankentyps, bei dem der vom Lichtsender kommende Lichtstrahl nur durch ein entsprechendes Beeinflussungselement zum Lichtempfänger zurück reflektiert wird.

Elektronische, berührungslos arbeitende Schaltgeräte sind anfangs mit einer Reihe von Problemen behaftet gewesen, gemessen an elektrischen, mechanisch betätigten Schaltgeräten, nämlich u.a. mit den Problemen «Erzeugung einer Speisespannung für den Oszillator», «Ausbildung des Oszillators», «Einschaltimpulsverhinderung», «Kurzschlussfestigkeit». Mit diesen Problemen und deren Lösungen (und mit anderen bei elektronischen, berührungslos arbeitenden Schaltgeräten relevanten Problemen und deren Lösungen) befassen sich z.B. die deutschen Offenlegungsschriften bzw. Auslegeschriften bzw. Patentschriften 1 951 137, 1 966 178, 1 966 213, 2 036 840, 2 127 956, 2 203 038, 2 203 039, 2 203 040, 2 203 906, 2 330 233, 2 331 732, 2 356 490, 2 613 423, 2 616 265,

2 616 773, 2 628 427, 2 711 877, 2 744 785, 2 943 911, 3 004 829, 3 038 102, 3 038 141 und 3 038 692.

Wie bereits ausgeführt, werden elektronische Schaltgeräte der in Rede stehenden Art in Mess-, Steuer- und Regelkreisen verwendet. Folglich hängt von der Funktionstüchtigkeit dieser Schaltgeräte häufig die Funktionstüchtigkeit der damit ausgerüsteten Mess-, Steuer- und Regelkreise — und damit die Funktionstüchtigkeit von Maschinen und Anlagen ab, zu denen solche Mess-, Steuer- und Regelkreise gehören.

Nun lässt sich nicht verhindern, dass an elektronischen Schaltgeräten der in Rede stehenden Art und an den an solche Schaltgeräte angeschlossenen Aussenleitern Fehler auftreten. Um solche Fehler erkennen zu können, werden elektronische Schaltgeräte (und deren Aussenleiter) «fehlerüberwacht», nämlich in Schaltungsanordnungen der eingangs beschriebenen Art, in denen also an den Ausgang des elektronischen Schaltgerätes ein Fehlerindikator angeschlossen ist und mit Hilfe des Fehlerindikators feststellbar ist, ob das elektronische Schaltgerät und/oder ein an das elektronische Schaltgerät angeschlossener Aussenleiter einen Fehler aufweist.

Bei einer bekannten Schaltungsanordnung der in Rede stehenden Art weist das elektronische Schaltgerät zwei antivalente Ausgänge auf und gibt der Fehlerindikator dann ein Fehlersignal ab, wenn am Fehlerindikator nicht ununterbrochen zwei antivalente Ausgangssignale ankommen. Dabei ist jedoch nicht ausgeschlossen, dass das elektronische Schaltgerät und/oder ein an das elektronische Schaltgerät angeschlossener Aussenleiter einen Fehler aufweist und der Fehlerindikator gleichwohl kein Fehlersignal abgibt.

Zur Lösung der Aufgabe, eine Schaltungsanordnung der in Rede stehenden Art anzugeben, bei der der Fehlerindikator mit an Sicherheit grenzender Wahrscheinlichkeit dann und nur dann ein Fehlersignal abgibt, wenn das elektronische Schaltgerät und/oder ein an das elektronische Schaltgerät angeschlossener Aussenleiter einen Fehler aufweist, ist es bereits bekannt, zwischen dem Anwesenheitsindikator und dem Steuereingang des elektronischen Schalters ein exklusives ODER-Gatter zu schalten, wobei der erste Eingang des exklusiven ODER-Gatters an den Ausgang des Anwesenheitsindikators oder eines dem Anwesenheitsindikator nachgeschalteten Schaltverstärkers und der Ausgang des exklusiven ODER-Gatters an den Steuereingang des elektronischen Schalters angeschlossen sind, an den zweiten Eingang des exklusiven ODER-Gatters des elektronischen Schaltgerätes einen Überwachungsimpulse abgebenden — externen oder internen — Überwachungsimpulsgenerator anzuschliessen und den Fehlerindikator so auszugestalten, dass er dann ein Fehlersignal abgibt, wenn an ihm keine ununterbrochene Folge von Überwachungsimpulsen ankommt.

Bei der bekannten, zuvor beschriebenen Schaltungsanordnung ist also eine «dynamische» Überwachung des elektronischen Schaltgerätes und der an das elektronische Schaltgerät angeschlossenen Aussenleiter verwirklicht. Die Überwachungsimpulse, dem elektronischen Schaltgerät von aussen zugeführt oder innerhalb des elektronischen Schaltgerätes erzeugt, gelangen nur dann in ununterbrochener Folge zu dem Fehlerindikator, wenn das elektronische Schaltgerät und die an das elektronische Schaltgerät angeschlossenen Aussenleiter fehlerfrei sind. Dadurch, dass bei dem elektronischen Schaltgerät zwischen dem Anwesenheitsindikator und dem Steuereingang des elektronischen Schalters ein exklusives ODER-Gatter geschaltet ist und an den zweiten Eingang des exklusiven ODER-Gatters fortlaufend Überwachungsimpulse gegeben werden, sind die Teile des elektronischen Schaltgerätes, die besonders fehlergefährdet sind, insbesondere auch der elektronische Schalter des elektronischen Schaltgerätes, und die an das elektronische Schaltgerät angeschlossenen Aussenleiter in die Fehlerüberwachung einbezogen.

Bei der bekannten Schaltungsanordnung, von der die Erfindung ausgeht, ist das elektronische Schaltgerät noch nicht insgesamt «dynamisch» überwacht, so dass der Erfindung die Aufgabe zugrunde liegt, eine Schaltungsanordnung der in Rede stehenden Art anzugeben, bei der der Fehlerindikator mit noch grösserer Sicherheit dann und nur dann ein Fehlersignal abgibt, wenn das elektronische Schaltgerät, wo auch immer, und/oder ein an das elektronische Schaltgerät angeschlossener Aussenleiter einen Fehler aufweist.

Das erfindungsgemässe elektronische Schaltgerät, bei dem die zuvor hergeleitete und dargelegte Aufgabe gelöst ist, ist zunächst und im wesentlichen dadurch gekennzeichnet, dass der Anwesenheitsindikator, z.B. ein Oszillator, zu Überprüfungs- bzw. Überwachungszwecken mit Hilfe der Überprüfungsimpulse zyklisch sich wiederholend durch «künstliche» Bedämpfung oder Entdämpfung zur Abgabe von Steuerimpulsen anregbar ist und die Überwachungsimpulse am Ausgang des elektronischen Schaltgerätes durch die Steuerimpulse entstehen.

Bei der Schaltanordnung, von der die Erfindung konkret ausgeht, kann der Anwesenheitsindikator des elektronischen Schaltgerätes insbesondere ein von aussen beeinflussbarer, d.h. bedämpfbarer Oszillator sein. Davon soll im folgenden immer ausgegangen werden, — aber nur, um die Lehre der Erfindung besser konkret beschreiben zu können. Selbstverständlich ist alles da, was im folgenden in Verbindung mit einem als Oszillator ausgeführten Anwesenheitsindikator beschrieben wird, auf alle Schaltungsanordnungen der in Rede stehenden Art entsprechend anwendbar, bei denen das elektronische Schaltgerät einen anderen Anwesenheitsindikator aufweist.

Ist bei einer erfindungsgemässen Schaltungsanordnung der Anwesenheitsindikator des elektronischen Schaltgerätes als Oszillator ausgeführt, so bedeutet das Merkmal, wonach der Anwesenheitsindikator mit Hilfe der Überprüfungsimpulse zur Abgabe von Steuerimpulsen anregbar ist, dass der Oszillator mit Hilfe der Überprüfungsimpulse bedämpfbar und/oder entdämpfbar ist.

Der wesentliche Gedanke der Erfindung besteht also darin, zu Überprüfungs- bzw. Überwachungszwecken zyklisch sich wiederholend das zu der erfindungsgemässen Schaltungsanordnung gehörende elektronische Schaltgerät «künstlich» den funktionsgemässen äusseren Beeinflussungsmöglichkeiten entsprechend zu beeinflussen. Handelt es sich z.B. um ein als Schliesser ausgeführtes Schaltgerät, also um ein Schaltgerät, dessen elektronischer Schalter durchschaltet, wenn der Oszillator bedämpft wird, dann führt die zyklisch wiederkehrende «künstliche» Bedämpfung dazu, dass zyklisch sich wiederholend überprüft und damit ständig überwacht wird, ob das Schaltgerät funktionsgemäss bedämpfbar ist und dabei der elektronische Schalter durchschaltet.

Im folgenden wird die Erfindung anhand von lediglich Ausführungsbeispiele darstellenden Zeichnungen, auch in bezug auf weitere erfindungswesentliche Merkmale, näher erläutert; es zeigt

Fig. 1 ein Blockschaltbild zur Erläuterung von Aufbau und Funktionsweise einer erfindungsgemässen Schaltungsanordnung,

Fig. 2 eine grafische Darstellung zur Erläuterung eines ersten Ausführungsbeispiels einer erfindungsgemässen Schaltungsanordnung,

Fig. 3 eine grafische Darstellung zur Erläuterung eines zweiten Ausführungsbeispiels einer erfindungsgemässen Schaltungsanordnung,

Fig. 4 ein erstes konkretes Ausführungsbeispiel eines elektronischen Schaltgerätes einer erfindungsgemässen Schaltungsanordnung,

Fig. 5 ein zweites konkretes Ausführungsbeispiel eines elektronischen Schaltgerätes einer erfindungsgemässen Schaltungsanordnung,

Fig. 6 ein anderes als das in Fig. 5 dargestellte Ausführungsbeispiel eines Überprüfungsimpulsgenerators für das in Fig. 5 dargestellte elektronische Schaltgerät,

Fig. 7 nochmals ein anderes als das in Fig. 5 dargestellte Ausführungsbeispiel eines Überprüfungsimpulsgenerators für das in Fig. 5 dargestellte elektronische Schaltgerät,

Fig. 8 ein drittes konkretes Ausführungsbeispiel eines elektronischen Schaltgerätes einer erfindungsgemässen Schaltungsanordnung,

Fig. 9 ein viertes konkretes Ausführungsbeispiel eines elektronischen Schaltgerätes einer erfindungsgemässen Schaltungsanordnung,

Fig. 10 ein fünftes konkretes Ausführungsbeispiel eines elektronischen Schaltgerätes einer erfindungsgemässen Schaltungsanordnung,

Fig. 11 ein sechstes konkretes Ausführungsbeispiel eines elektronischen Schaltgerätes einer erfindungsgemässen Schaltungsanordnung,

Fig. 12 ein siebtes konkretes Ausführungsbeispiel eines elektronischen Schaltgerätes einer erfindungsgemässen Schaltungsanordnung,

Fig. 13 ein achtes konkretes Ausführungsbeispiel eines elektronischen Schaltgerätes einer erfindungsgemässen Schaltungsanordnung,

Fig. 14 ein erstes konkretes Ausführungsbeispiel eines Fehlerindikators einer erfindungsgemässen Schaltungsanordnung,

Fig. 15 ein zweites konkretes Ausführungsbeispiel eines Fehlerindikators einer erfindungsgemässen Schaltungsanordnung, die hier wiederum noch einen Sicherheitsschaltkreis aufweist.

Fig. 16 eine grafische Darstellung zur Erläuterung der Funktionsweise einer erfindungsgemässen Schaltungsanordnung, die aus dem in Fig. 5 dargestellten elektronischen Schaltgerät mit dem in Fig. 6 dargestellten Überprüfungsimpulsgenerator sowie aus dem in Fig. 14 dargestellten Fehlerindikator mit einem Sicherheitsschaltkreis besteht,

Fig. 17 eine grafische Darstellung zur Erläuterung der Funktionsweise einer erfindungsgemässen Schaltungsanordnung, die aus dem in Fig. 5 dargestellten elektronischen Schaltgerät, einem hier teilweise zentral verwirklichten Überprüfungsimpulsgenerator sowie aus dem in Fig. 15 dargestellten Fehlerindikator mit einem Sicherheitsschaltkreis besteht,

Fig. 18 ein drittes konkretes Ausführungsbeispiel eines elektronischen Schaltgerätes einer erfindungsgemässen Schaltungsanordnung, hier mit einem Überprüfungsimpulsgenerator,

Fig. 19 eine grafische Darstellung zur Erläuterung des in Fig. 18 dargestellten elektronischen Schaltgerätes einer erfindungsgemässen Schaltungsanordnung und

Fig. 20 ein drittes konkretes Ausführungsbeispiel eines Fehlerindikators einer erfindungsgemässen Schaltungsanordnung, wobei dieser Fehlerindikator zum Anschluss an den in Fig. 18 dargestellten elektronischen Schalter geeignet ist.

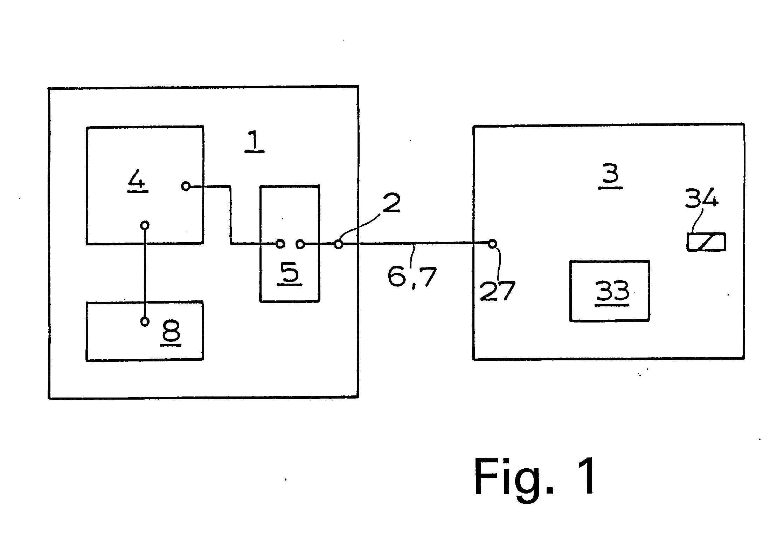

Die Fig. 1 zeigt — in Form eines Blockschaltbildes — eine Schaltungsanordnung mit einem elektronischen, berührungslos arbeitenden Schaltgerät 1 und einem an den Ausgang 2 des elektronischen Schaltgerätes 1 angeschlossenen Fehlerindikator 3. Das elektronische Schaltgerät 1 weist einen von aussen beeinflussbaren Anwesenheitsindikator, im vorliegenden Fall einen Oszillator 4, und einen von dem Oszillator 4 steuerbaren elektronischen Schalter 5, z.B. einen Transistor, auf. Mit Hilfe des Fehlerindikators 3 ist feststellbar, ob das elektronische Schaltgerät 1 und/oder ein an das elektronische Schaltgerät 1 angeschlossener Aussenleiter 6, 7 einen Fehler aufweist.

Zur Realisierung der Feststellung, ob das elektronische Schaltgerät 1 und/oder ein an das elektronische Schaltgerät 1 angeschlossener Aussenleiter 6, 7 einen Fehler aufweist, ist zunächst ein Überprüfungsimpulse abgebender Überprüfungsimpulsgenerator 8 vorgesehen. (In dem Ausführungsbeispiel, das Fig. 1 — in Form eines Blockschaltbildes — zeigt, ist der Überprüfungsimpulsgenerator 8 intern innerhalb des elektronischen Schaltgerätes 1 realisiert. Es besteht aber auch die Möglichkeit, was später noch näher beschrieben wird, den Überprüfungsimpulsgenerator 8 — teilweise oder ganz — ausserhalb des elektronischen Schaltgerätes 1, also extern, z.B. innerhalb des Fehlerindikators 3, zu realisieren.) Das elektronische Schaltgerät 1 gibt dann, wenn es keinen Fehler aufweist, an seinem Ausgang 2 eine ununterbrochene Folge von Überwachungsimpulsen ab. Der Fehlerindikator 3 gibt dann und nur dann ein Fehlersignal ab, wenn am Fehlerindikator 3 keine ununterbrochene Folge von Überwachungsimpulsen — vom elektronischen Schaltgerät 1 kommend — ankommt.

Bei der erfindungsgemässen Schaltungsanordnung ist der Anwesenheitsindikator, im dargestellten Ausführungsbeispiel also der Oszillator 4, mit Hilfe der — vom Überprüfungsimpulsgenerator 8 kom-

menden — Überprüfungsimpulse zur Abgabe von Steuerimpulsen anregbar und entstehen die Überwachungsimpulse am Ausgang 2 des elektronischen Schaltgerätes 1 durch die Steuerimpulse, — zu dessen Abgabe der Oszillator 4 mit Hilfe der — vom Überprüfungsimpulsgenerator 8 kommenden — Überprüfungsimpulse anregbar ist.

Auch im folgenden soll immer davon ausgegangen werden, dass der Anwesenheitsindikator des elektronischen Schaltgerätes 1 ein von aussen beeinflussbarer, d.h. bedämpfbarer (und wieder entdämpfbarer) Oszillator 4 ist. Also bedeutet das Merkmal, wonach der Anwesenheitsindikator mit Hilfe der Überprüfungsimpulse zur Abgabe von Steuerimpulsen anregbar ist, dass der Oszillator 4 mit Hilfe der Überprüfungsimpulse bedämpfbar und/oder entdämpfbar ist. Der wesentlichen Gedanke der Erfindung besteht also darin, zu Überprüfungs- bzw. Überwachungszwecken zyklisch sich wiederholend das zu der erfindungsgemässen Schaltungsanordnung gehörende elektronische Schaltgerät 1 «künstlich» den funktionsgemässen äusseren Beeinflussungsmöglichkeiten entsprechend zu beeinflussen. Handelt es sich z.B. um ein als Schliesser ausgeführtes elektronisches Schaltgerät 1, wovon im folgenden immer ausgegangen werden soll, also um ein elektronisches Schaltgerät 1, dessen elektronischer Schalter 5 durchschaltet, wenn der Oszillator 4 bedämpft wird, dann führt die zyklisch wiederkehrende «künstliche» Bedämpfung und Entdämpfung dazu, dass zyklisch sich wiederholend überprüft und damit ständig überwacht wird, ob der Oszillator 4 des elektronischen Schaltgerätes 1 funktionsgemäss bedämpfbar und entdämpfer ist und ob dabei der elektronische Schalter 5 durchschaltet und öffnet.

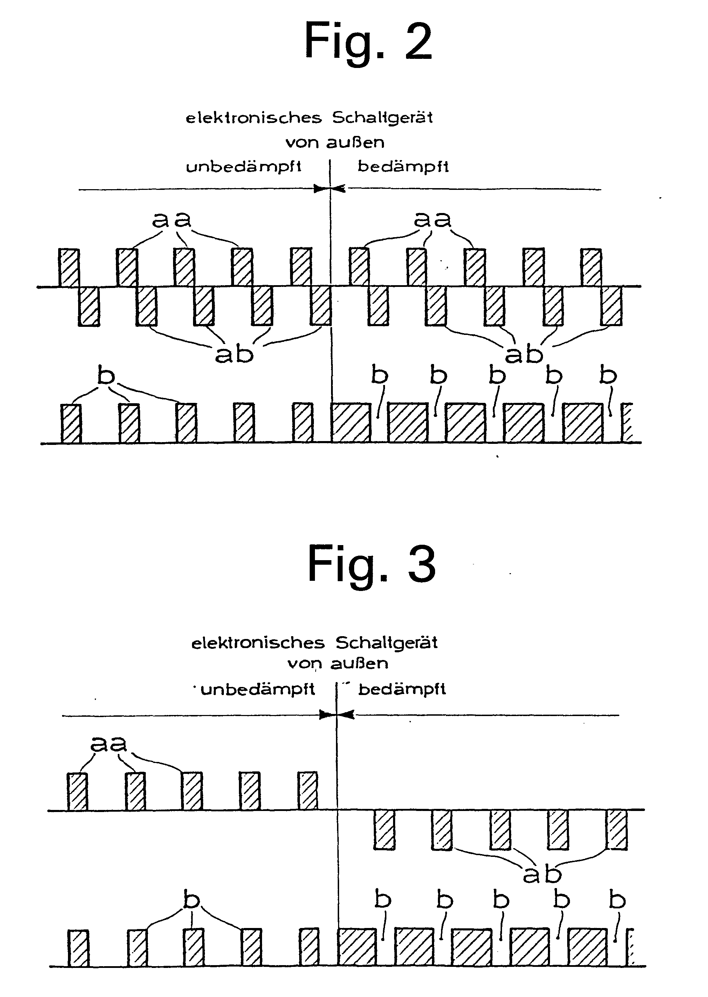

Aus den Fig. 2 und 3, die grafische Darstellungen zur Erläuterung der Funktionsweise der erfindungsgemässen Schaltungsanordnung zeigen, ist der zuvor erläuterte wesentliche Gedanke der Erfindung erkennbar:

Im oberen Teil der Fig. 2 und 3 sind jeweils die — vom Überprüfungsimpulsgenerator 8 kommenden — Überprüfungsimpulse a dargestellt, und zwar den Oszillator 4 bedämpfende Überprüfungsimpulse aa und den Oszillator 4 entdämpfende Überprüfungsimpulse ab, während im unteren Teil der Fig. 2 und 3 jeweils die — dem eigentlichen Ausgangssignal des elektronischen Schaltgerätes 1 überlagerten — Überprüfungsimpulse b dargestellt sind. Bei dem der Fig. 2 zugrundeliegenden Ausführungsbeispiel der erfindungsgemässen Schaltungsanordnung gibt der Überwachungsimpulsgenerator 8 den Oszillator 4 bedämpfende Überprüfungsimpulse aa und den Oszillator 4 entdämpfende Überprüfungsimpulse ab ab, unabhängig davon, ob das elektronische Schaltgerät 1, d.h. dessen Oszillator 4, vom aussen unbedämpft oder bedämpft ist. Da, wie auch Fig. 2 zeigt, der unbedämpfte Oszillator 4 des elektronischen Schaltgerätes 1 durch entdämpfende Überprüfungsimpulse ab nicht mehr signifikant entdämpft und der bedämpfte Oszillator 4 des elektronischen Schaltgerätes 1 durch dämpfende Überprüfungsimpulse aa nicht mehr signifikant bedämpft werden kann, kann, was in Fig. 3 dargestellt ist, darauf verzichtet werden, dann, wenn der Oszillator 4 des elektronischen Schaltgerätes 1 von aussen unbedämpft ist, entdämpfende Überprüfungsimpulse ab bzw. dann, wenn der Oszillator 4 des elektronischen Schaltgerätes 1 von aussen bedämpft ist, bedämpfende Überprüfungsimpulse aa zu erzeugen.

In bestimmten Fällen kann es zulässig sein, bei einer erfindungsgemässen Schaltungsanordnung das elektronische Schaltgerät 1 und die an das elektronische Schaltgerät 1 angeschlossenen Aussenleiter 6, 7 nur im «kritischen Schaltzustand» einer Fehlerüberwachung zu unterziehen. Ist bei einem als Schliesser ausgeführten elektronischen Schaltgerät 1 der leitende Zustand des elektronischen Schalters 5 der «kritische Schaltzustand» und bei einem als Öffner ausgeführten elektronischen Schaltgerät der gesperrte Zustand des elektronischen Schalters der «kritische Schaltzustand», so reicht es also aus, bei einem als Schliesser ausgeführten elektronischen Schaltgerät 1 den Oszillator 4 nur dann, wenn er von aussen bedämpft ist, mit Hilfe der Überprüfungsimpulse zu entdämpfen, bzw. bei einem als Öffner ausgeführten elektronischen Schaltgerät den Oszillator 4 nur dann, wenn er von aussen unbedämpft ist, mit Hilfe der Überprüfungsimpulse zu bedämpfen.

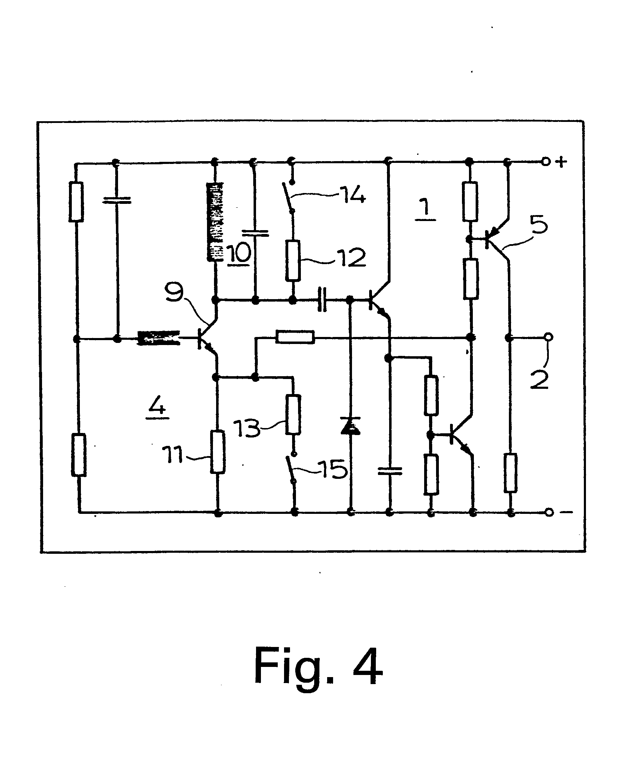

Bei dem in Fig. 4 dargestellten ersten konkreten Ausführungsbeispiel eines elektronischen Schaltgerätes 1 einer erfindungsgemässen Schaltungsanordnung weist der Oszillator 4 einen in Emitterschaltung betrieben Oszillatortransistor 9 auf und sind im Kollektorkreis des Oszillatortransistors 9 ein LC-Schwingkreis 10 und im Emitterkreis des Oszillatortransistors 9 ein Emitterwiderstand 11 vorgesehen. Hier ist dem LC-Schwingkreis 10 mit Hilfe von bedämpfenden Überprüfungsimpulsen ein Bedämpfungswiderstand 12 und/oder dem Emitterwiderstand 11 mit Hilfe von entdämpfenden Überprüfungsimpulsen ein Entdämpfungswiderstand 13 parallelschaltbar. Da bei dem in der Fig. 4 dargestellten Ausführungsbeispiel eines elektronischen Schaltgerätes 1 einer erfindungsgemässen Schaltungsanordnung ein Überrprüfungsimpulsgenerator nicht dargestellt ist, sind die zuvor angesprochenen Merkmale «Parallelschaltbarkeit eines Bedämpfungswiderstandes 12 mit Hilfe von bedämpfen Überprüfungsimpulsen» und «Parallelschaltbarkeit eines Entdämpfungswiderstandes 13 mit Hilfe von entdämpfenden Überprüfungsimpulsen» nur durch einen Bedämpfungsschalter 14 und einen Entdämpfungsschalter 15 angedeutet.

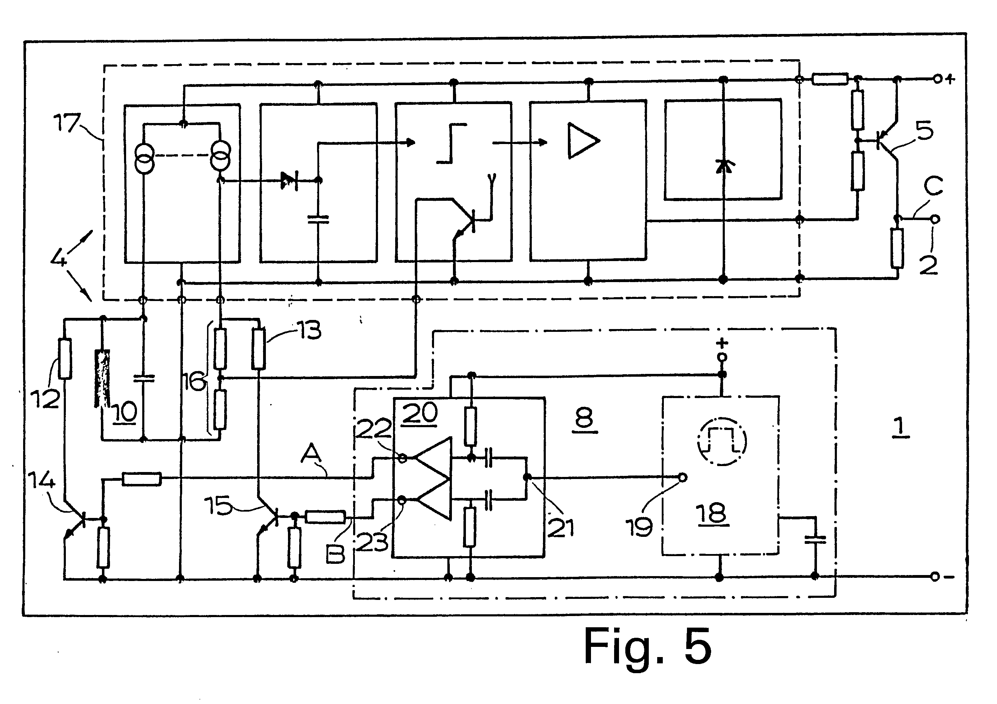

Das in Fig. 4 dargestellte Ausführungsbeispiel eines elektronischen Schaltgerätes 1 einer erfindungsgemässen Schaltungsanordnung ist insoweit mit einem Mangel behaftet, als der Bedämpfungsschalter 14 und der Entdämpfungsschalter 15 an unterschiedlichen Potentialen liegen; der Bedämpfungsschalter 14 liegt an positivem Potential, der Entdämpfungsschalter 15 an negativem Potential. Von diesem Mangel befreit ist das in Fig. 5 dargestellte Ausführungsbeispiel eines elektronischen Schaltgerätes 1 einer erfindungsgemässen Schaltungsanordnung, bei der der Oszillator 4 einen einseitig an Masse liegenden LC-Schwingkreis 10 und ein ebenfalls einseitig an Masse liegendes Abgleich- und/oder Hysteresewiderstandsnetzwerk 16 aufweist; im übrigen sind bei diesem Asuführungsbeispiel die meisten Bauelemente monolithisch integriert, nämlich in einem integrierten Schaltkreis 17 realisiert, der und dessen einzelne Funktionsgruppen für sich bekannt sind und folglich hier der Erläuterung nicht bedürfen. Hier ist dem LC-Schwingkreis 10 mit Hilfe von bedämpfenden Überprüfungsimpulsen ein Bedämpfungswiderstand 12 und/oder dem Abgleich- und/oder Hysteresewiderstandsnetzwerk 16 mit Hilfe von entdämpfenden Überprüfungsimpulsen ein Entdämpfungswiderstand 13 parallelschaltbar.

Den in den Fig. 5 sowie 8 bis 13 dargestellten Ausführungsbeispielen von elektronischen Schaltgeräten 1 einer erfindungsgemässen Schaltungsanordnung ist gemeinsam, dass sie einerseits einen einseitig an Masse liegenden LC-Schwingkreis 10 und ein ebenfalls einseitig an Masse liegendes Abgleich- und/oder Hysteresewiderstandsnetzwerk 16 aufweisen, dass andererseits die meisten Bauelemente monolithisch integriert, nämlich in einem integrierten Schaltkreis 17 realisiert sind. Unterschiedlich sind bei den in den Fig. 5 sowie 8 bis 13 dargestellten Ausführungsbeispielen von elektronischen Schaltgeräten 1 einer erfindungsgemässen Schaltungsanordnung die realisierten Be- und/oder Entdämpfungsmöglichkeiten des Oszillators 4, zu dem jeweils neben dem LC-Schwingkreis 10 und dem Abgleich- und/oder Hysteresewiderstandsnetzwerk 16 innerhalb des integrierten Schaltkreises 17 realisierte Bauelemente gehören. Unterschiedlich sind auch die erforderlichen bedämpfenden bzw. entdämpfenden Überprüfungsimpulse.

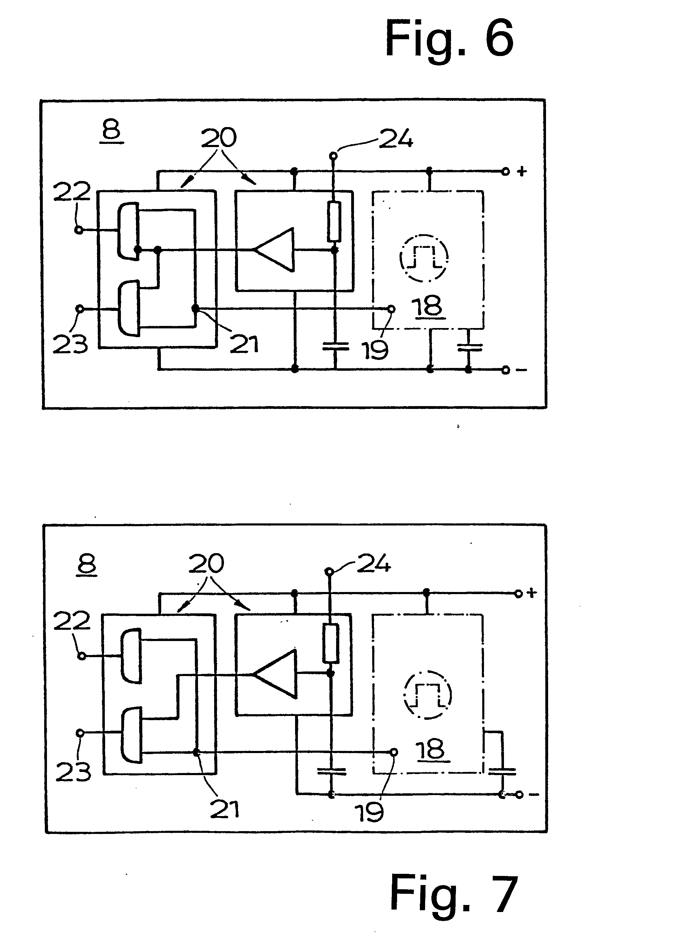

Folglich sollen nunmehr zunächst die dargestellten Ausführungsbeispiele von Überprüfungsimpulsgeneratoren 8 beschrieben werden, nämlich der in der Fig. 5 in Verbindung mit einem elektronischen Schaltgerät 1 dargestellte Überprüfungsimpulsgenerator 8 und die in den Fig. 6 und 7 für sich dargestellten Überprüfungsimpulsgeneratoren 8.

Zunächst gehört zu jedem Überprüfungsimpulsgenrator 8 ein Taktimpulsgenrator 18 mit einem Taktimpulsausgang 19 sowie ein Taktimpulsverarbeitungsnetzwerk 20 mit einem Taktimpulseingang 21 und zwei Überprüfungsimpulsausgängen 22, 23, wobei an dem Überprüfungsimpulsausgang 22 bedämpfende Überprüfungsimpulse und an dem Überprüfungsimpulsausgang 23 entdämpfende Überprüfungsimpulse anstehen. Wie bereits ausgeführt, kann jedes elektronische Schaltgerät 1 einer erfindungsgemässen Schaltungsanordnung einen eigenen — kompletten — Überprüfungsimpulsgenerator 8 aufweisen, wie das in Fig. 5 dargestellt ist. Es kann jedoch zweckmässig sein, für eine Mehrzahl von elektronischen Schaltgeräten 1 einer erfindungsgemässen Schaltungsanordnung zentral einen Überprüfungsimpulsgenerator 8 vorzusehen, zumindest aber nur einen Taktimpulsgenerator 18 zentral vorzusehen.

Im Ausführungsbeispiel nach Fig. 5 ist das Taktimpulsverarbeitungsnetzwerk 20 des Überprüfungsimpulsgenerators 8 als Impulsverdoppler ausgeführt; aus den am Taktimpulseingang 21 ankommenden Taktimpulsen des Taktimpulsgenerators 18 werden zwei aufeinanderfolgende, gleichlange Überprüfungsimpulse, die an den Überprüfungsimpulsausgängen 22, 23 zur Verfügung stehen und von dort den Bedämpfungsschalter 14 und den Entdämpfungsschalter 15 ansteuern. Dem in Fig. 5 dargestellten Ausführungsbeispiel entspricht die grafische Darstellung nach Fig. 2.

In den Ausführungsbeispielen nach den Fig. 6 und 7 weist das Taktimpulsverarbeitungsnetzwerk 20 des Überprüfungsimpulsgenerators 8 zusätzlich noch einen Ansteuereingang 24 auf, der mit einem dem eigentlichen Ausgangssignal des elektronischen Schaltgerätes 1 entsprechenden Ansteuersignal beaufschlagt wird. Bei diesen Ausführungsbeispielen muss also jedenfalls das Taktimpulsverarbeitungsnetzwerk 20 des Überprüfungsimpulsgenerators 8 Teil des jeweiligen elektronischen Schaltgerätes 1 sein.

Abhängig vom eigentlichen Ausgangssignal des elektronischen Schaltgerätes 1 werden im Ausführungsbeispiel nach Fig. 6 entweder nur bedämpfende Überprüfungsimpulse — am Überprüfungsimpulsausgang 22 des Taktimpulsverarbeitungsnetzwerkes 20 und damit des Überprüfungsimpulsgenerators 8 — oder nur entdämpfende Überprüfungsimpulse — am Überprüfungsimpulsausgang 23 des Taktimpulsverarbeitungsnetzwerkes 20 und damit des Überprüfungsimpulsgenerators 8 — zur Verfügung gestellt. Dem in Fig. 6 dargestellten Ausführungsbeispiel entspricht die grafische Darstellung nach Fig. 3.

Gegenüber dem zuvor beschriebenen Ausführungsbeispiel nach Fig. 6 ist das in Fig. 7 dargestellte Ausführungsbeispiel nur geringfügig modifiziert, nämlich insoweit, als die bedämpfenden Überprüfungsimpulse — am Überprüfungsimpulsausgang 22 des Taktimpulsverarbeitungsnetzwerkes 20 und damit des Überprüfungsimpulsgenerators 8 — ununterbrochen zur Verfügung stehen, während die entdämpfenden Überprüfungsimpulse — am Überprüfungsimpulsausgang 23 des Taktimpulsverarbeitungsnetzwerkes 20 und damit des Überprüfungsimpulsgenerators 8 — abhängig vom eigentlichen Ausgangssignal des elektronischen Schaltgerätes 1 sind.

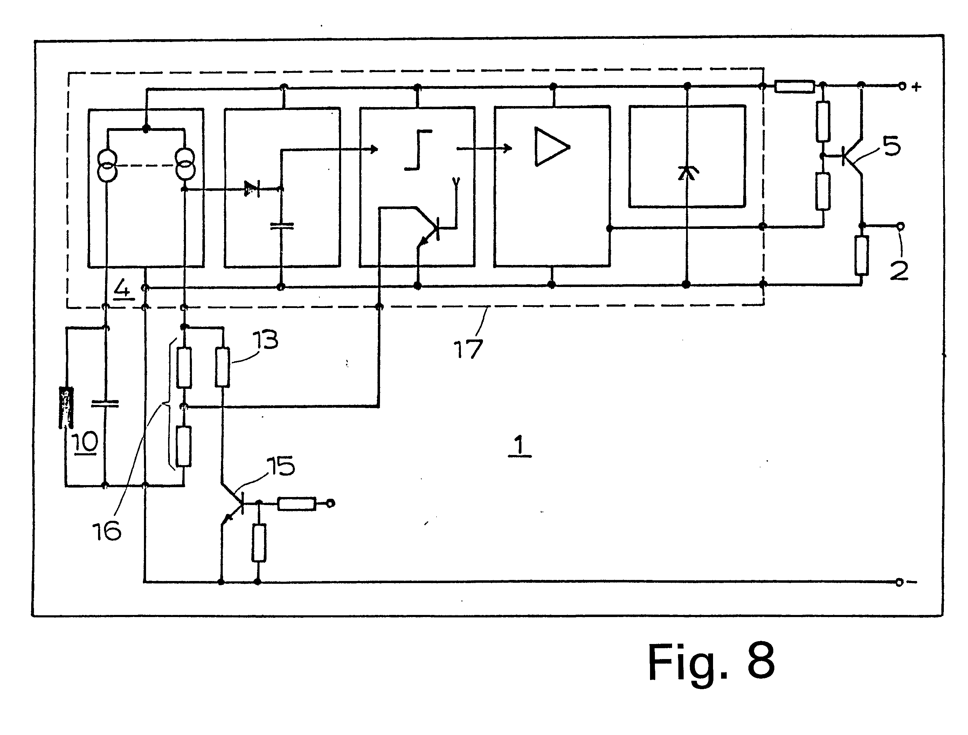

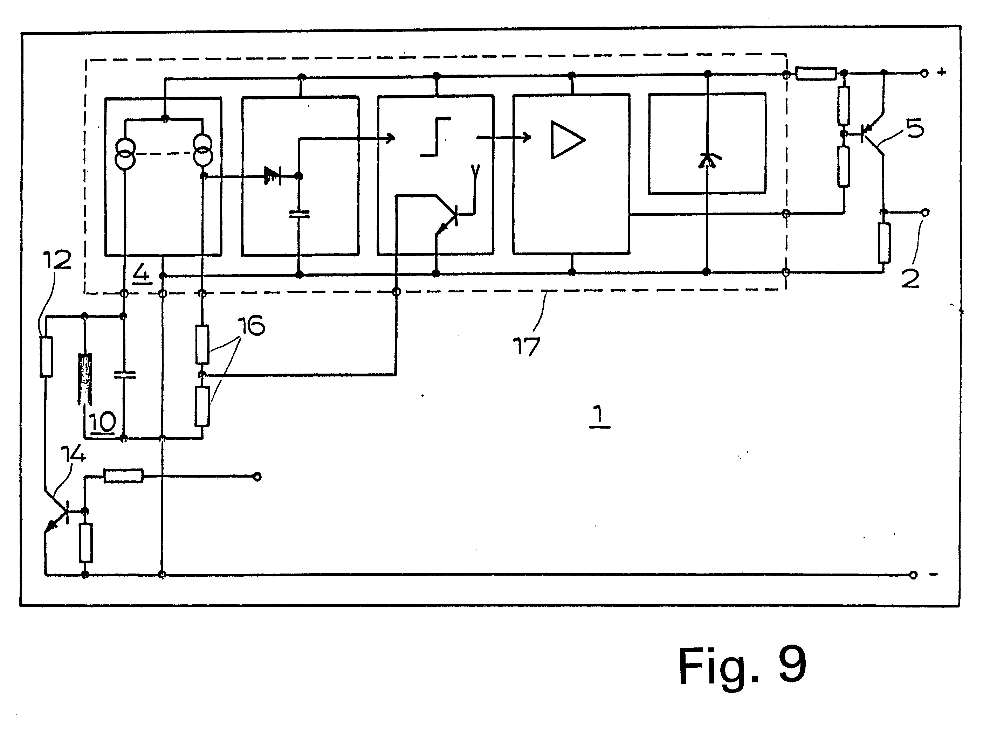

Wie bereits ausgeführt, kann es zulässig sein, bei einer erfindungsgemässen Schaltungsanordnung das elektronische Schaltgerät 1 und die an das elektronische Schaltgerät 1 angeschlossenen Aussenleiter 6, 7 nur im «kritischen Schaltzustand» einer Fehlerüberwachung zu unterziehen. In diesem Fall genügt es, unabhängig vom eigentlichen Ausgangssignal des elektronischen Schaltgerätes 1 zyklisch entweder, wie in Fig. 8 dargestellt, den Entdämpfungsschalter 15 mit entdämpfenden Überprüfungsimpulsen oder, wie in Fig. 9 dargestellt, den Bedämpfungsschalter 14 mit bedämpfenden Überprüfungsimpulsen anzusteuern. In diesen Fällen gehört zum Überprüfungsimpulsgenerator 8 also nur der Taktimpulsgenerator 18, wird also ein Taktimpulsverarbeitungsnetzwerk 20 nicht benötigt.

In den in den Fig. 5 sowie 8 und 9 dargestellten Ausführungsbeispielen eines elektronischen Schaltgerätes 1 einer erfindungsgemässen Schaltungsanordnung erfolgt das Bedämpfen des Oszillators 4 dadurch, dass im LC-Schwingkreis 10 ein Bedämpfungswiderstand 12 parallel geschaltet wird, und das Entdämpfen des Oszillators 4 dadurch, dass dem Abgleich- und/oder Hysteresewiderstandsnetzwerk 16 ein Entdämpfungswiderstand 13 parallel geschaltet wird. Der Oszillator 4 des elektronischen Schaltgerätes 1 kann jedoch auch anders bedämpft und entdämpft werden.

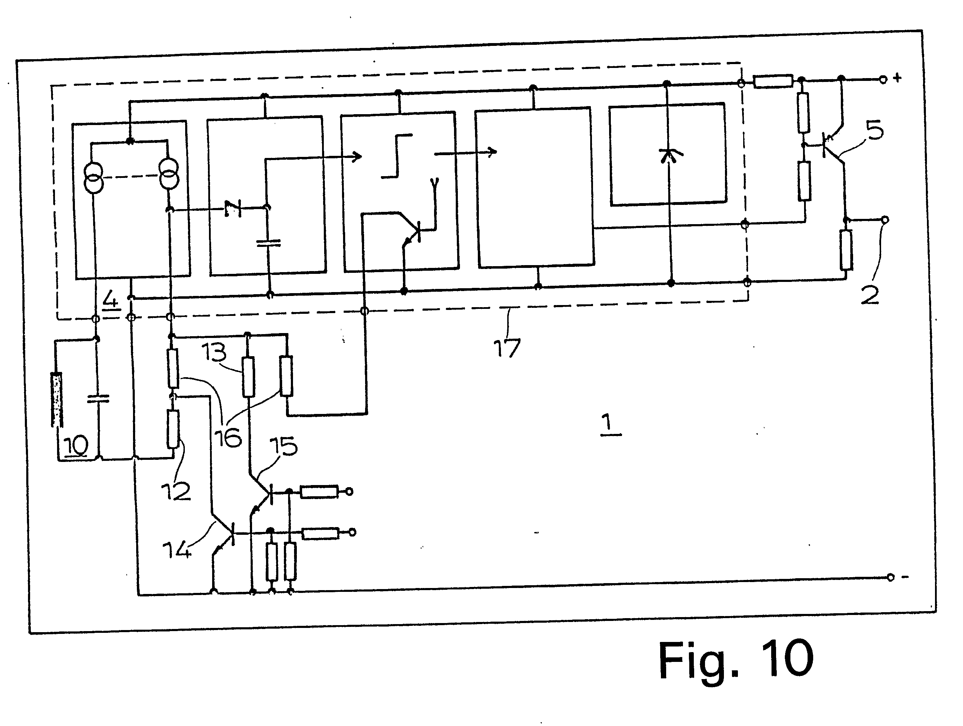

Im Ausführungsbeispiel nach Fig. 10 erfolgt das Bedämpfen des Oszillators 4 des elektronischen Schaltgerätes 1 dadurch, dass zu einem Teilwiderstand des Abgleich- und Hysteresewiderstandsnetzwerkes 16 der Bedämpfungswiderstand 12 in Reihe geschaltet wird, während das Entdämpfen dadurch erfolgt, dass dem zuvor angesprochenen Teilwiderstand des Abgleich- und Hysteresewiderstandsnetzwerkes 16 der Entdämpfungswiderstand 13 parallel geschaltet wird. Für dieses Ausführungsbeispiel können die in den Fig. 5 bis 7 dargestellten Überprüfungsimpulsgeneratoren 8 verwendet werden, jedoch müssen die bedämpfenden Überprüfungsimpulse invertiert werden.

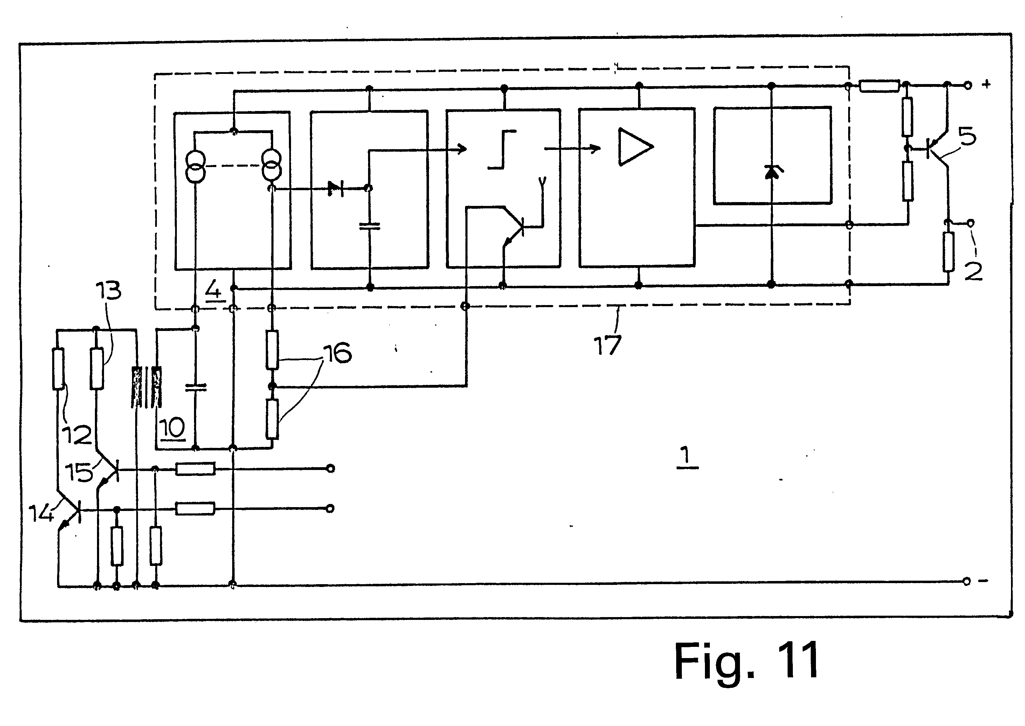

Im Ausführungsbeispiel nach Fig. 11 erfolgt das Bedämpfen des Oszillators 4 des elektronischen Schaltgerätes 1 dadurch, dass, wie in den Ausführungsbeispielen nach den Fig. 5 und 9, dem LC-Schwingkreis 10 der Bedämpfungswiderstand 12 parallel geschaltet wird, während das Entdämpfen dadurch erfolgt, dass ein normalerweise dem LC-Schwingkereis 10 parallel geschalteter Entdämpfungswiderstand 13 «weggeschaltet» wird. Für dieses Ausführungsbeispiel können wiederum die in den Fig. 5 bis 7 dargestellten Überprüfungsimpulsgeneratoren 8 verwendet werden, jedoch müssen diesmal die entdämpfenden Überprüfungsimpulse invertiert werden.

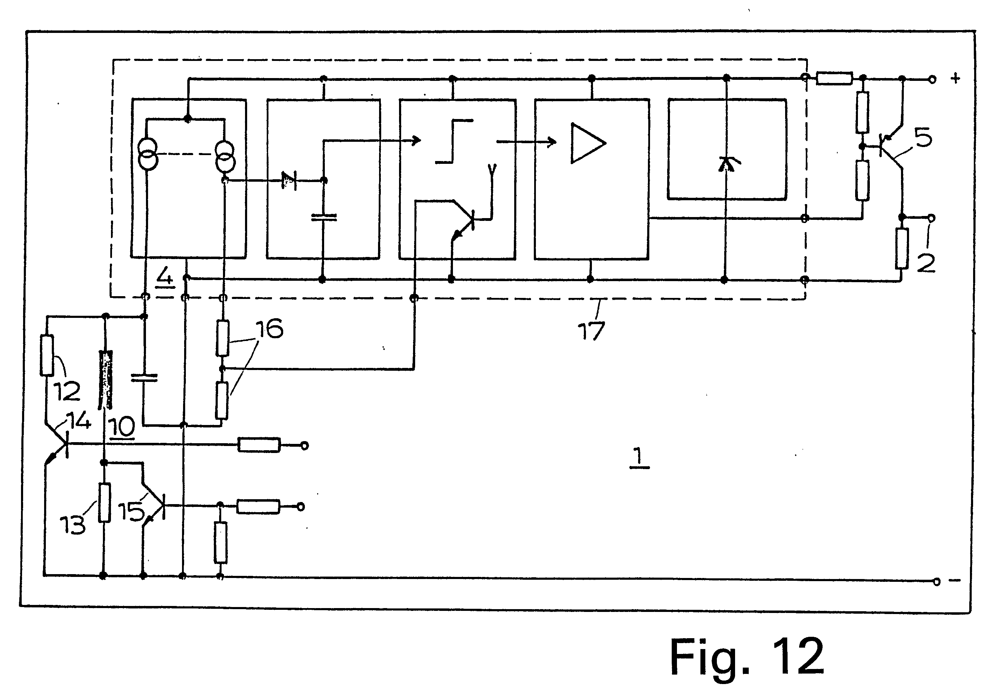

Das in Fig. 12 dargestellte Ausführungsbeispiel eines elektronischen Schaltgerätes 1 einer erfindungsgemässen Schaltungsanordnung entspricht weitgehend dem in Fig. 10 dargestellten Ausführungsbeispiel. Hier ist lediglich der im Ausführungsbeispiel nach Fig. 11 vorgesehene parallele Entdämpfungswiderstand 13 durch einen in Reihe geschalteten Entdämpfungswiderstand 13 ersetzt.

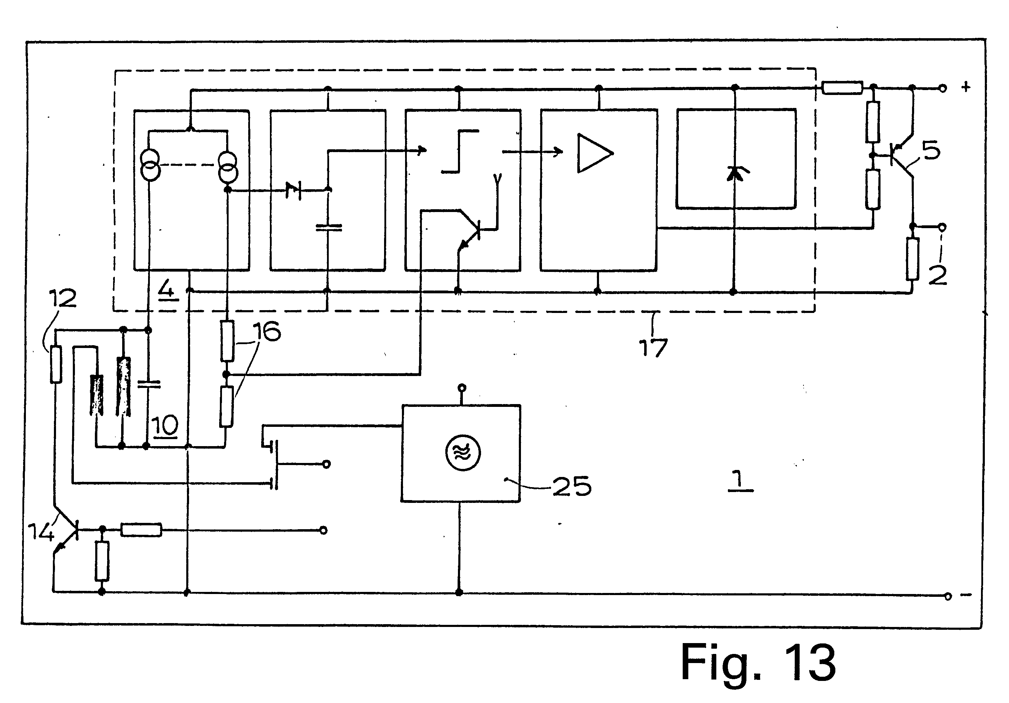

Auch das in Fig. 13 dargestellte Ausführungsbeispiel eines elektronischen Schaltgerätes 1 einer erfindungsgemässen Schaltungsanordnung entspricht weitgehend dem in Fig. 11 dargestellten Ausführungsbeispiel. Hier erfolgt das Entdämpfen des Oszillators 4 des elektronischen Schaltgerätes 1 dadurch, dass von einem hochfrequenten Entdämpfungsoszillator 25 kommende hochfrequente «Entdämpfungsenergie» eingespeist wird.

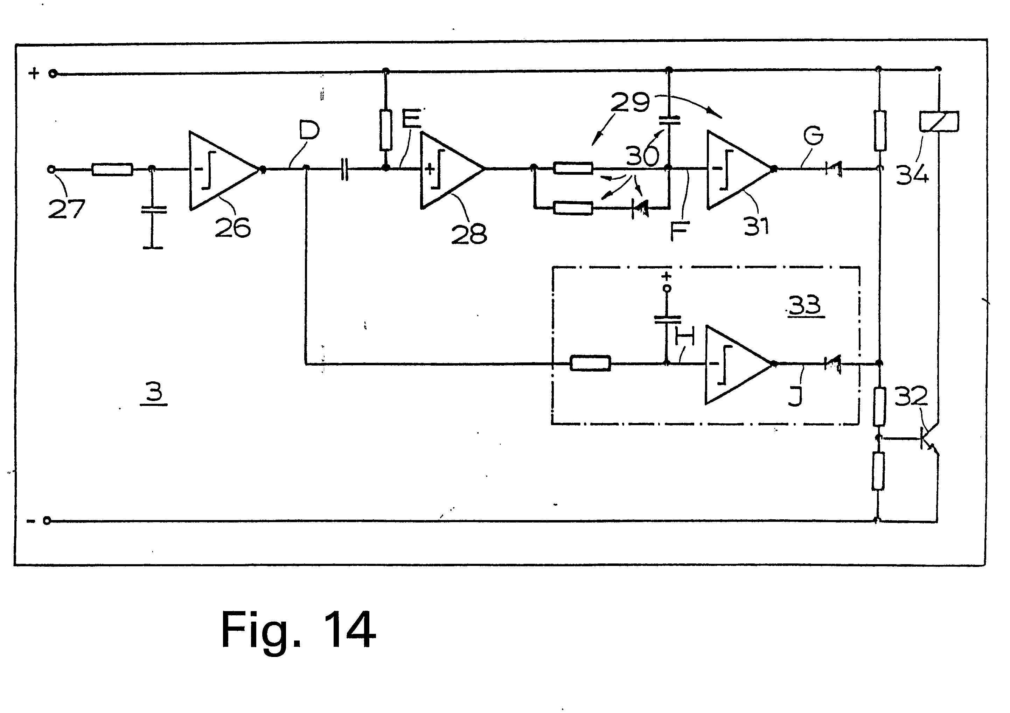

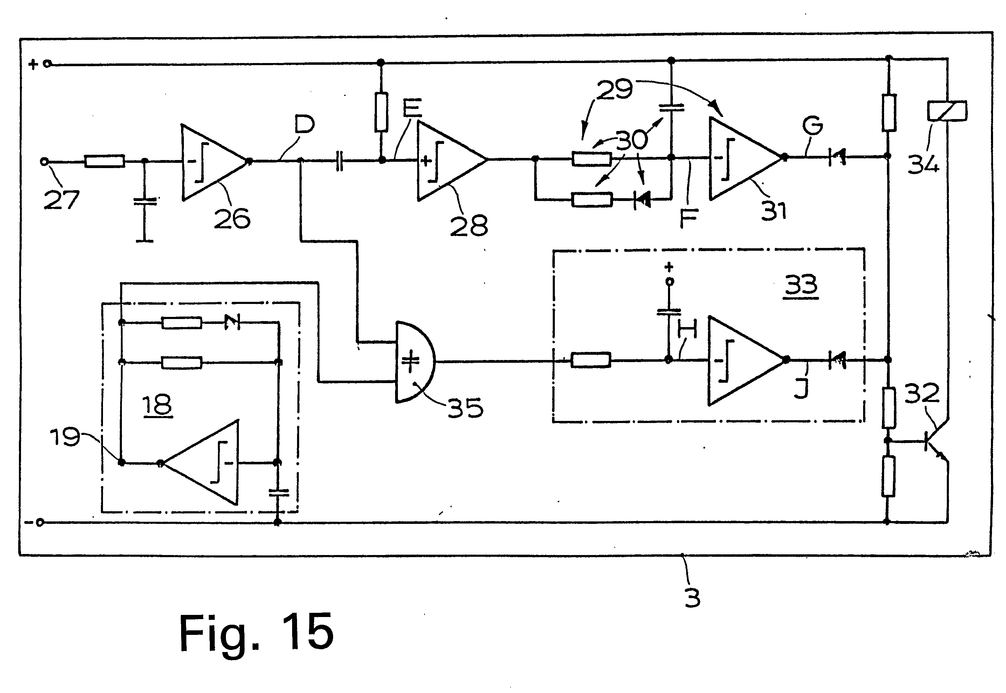

Zu der erfindungsgemässen Schaltungsanordnung gehört neben dem zuvor ausführlich beschriebenen elektronischen Schaltgerät 1 ein Fehlerindikator 3. Ausführungsbeispiele eines solchen Fehlerindikators 3 sind zunächst in den Fig. 14 und 15 dargestellt.

Im Ausführungsbeispiel nach Fig. 14 besteht der Fehlerindikator 3 in seinem grundsätzlichen Aufbau aus einem Eingangsverstärker 26 (mit einer Triggerstufe), der die am Überwachungsimpulseingang 27 vom Ausgang 2 des elektronischen Schaltgerätes 1 ankommenden Überwachungsimpulse formt und invertiert, aus einer Differenzierstufe 28, die zu jeder positiven Flanke eines vom Ausgang 2 des elektronischen Schaltgerätes 1 kommenden Überwachungsimpulses einen negativen Indikationsimpuls liefert, und aus einer Integrierstufe 29 mit einem Integriernetzwerk 30 und einem Integrierverstärker 31. Die Integrierstufe 29 liefert nur dann ein positives Ansteuersignal an einen Ausgangtransistor 32, wenn fortlaufend — mit einer bestimmten Folgefrequenz — am Überwachungsimpulseingang 27 — vom Ausgang 2 des elektronischen Schaltgerätes 1 — Überwachungsimpulse ankommen.

Im dargestellten Ausführungsbeispiel ist noch ein Sicherheitsschaltkreis 33 vorgesehen, der als Integrierstufe mit gleicher Zeitkonstante für die Ladung und die Entladung arbeitet. Der Sicherheitsschaltkreis 33 liefert gesiebte, stetige positive oder negative Ansteuersignale an den Ausgangtransistor 32. Folglich kann ein in Reihe mit dem Ausgangtransistor 32 liegendes Relais 34 nur dann anziehen, wenn am Überwachungsimpulseingang 27 des Fehlerindikators 3 — vom Ausgang 2 des elektronischen Schaltgerätes 1 kommend — einerseits eine ununterbrochene Folge von Überwachungsimpulsen ankommt, andererseits das eigentliche Ausgangssignal des elektronischen Schalters 1 positiv ist.

Das in Fig. 15 dargestellte Ausführungsbeispiel eines zu der erfindungsgemässen Schaltungsanordnung gehörenden Fehlerindikators 3 unterscheidet sich nur geringfügig von dem in Fig. 14 dargestellten Ausführungsbeispiel, nämlich dadurch, dass einerseits ein exklusives ODER-Gatter 35 vorgesehen ist, andererseits der funktionell zum Überprüfungsimpulsgenerator 8 gehörende Taktimpulsgenerator 18 in Verbindung mit dem Fehlerindikator 3 realisisert ist. Bei diesem Ausführungsbeispiel muss also der Taktimpulsausgang 19 des Taktimpulsgenerators 18 mit dem Taktimpulseingang 21 bzw. den Taktimpulseingängen 21 des innerhalb des elektronischen Schaltgerätes 1 verwirklichten Taktimpulsverarbeitungsnetzwerkes 20 bzw. der innerhalb der elektronischen Schaltgeräte 1 verwirklichten Taktimpulsverarbeitungsnetzwerke 20 verbunden werden.

Bei dem in Fig. 15 dargestellten Ausführungsbeispiel eines Fehlerindikators 3 einer erfindungsgemässen Schaltungsanordnung verknüpft das exklusive ODER-Gatter 35 die Taktimpulse und die von den Taktimpulsen letztes Endes verursachten Überwachungsimpulse, so dass am Ausgang des exklusiven ODER-Gatters 35 ein dem eigentlichen Ausgangssignal des elektronischen Schaltgerätes 1 entsprechendes Ausgangssignal vorliegt, also ein Ausgangssignal, das nicht, wie das Ausgangssignal am Ausgang 2 des elektronischen Schaltgerätes 1, mit den Überwachungsimpulsen überlagert ist.

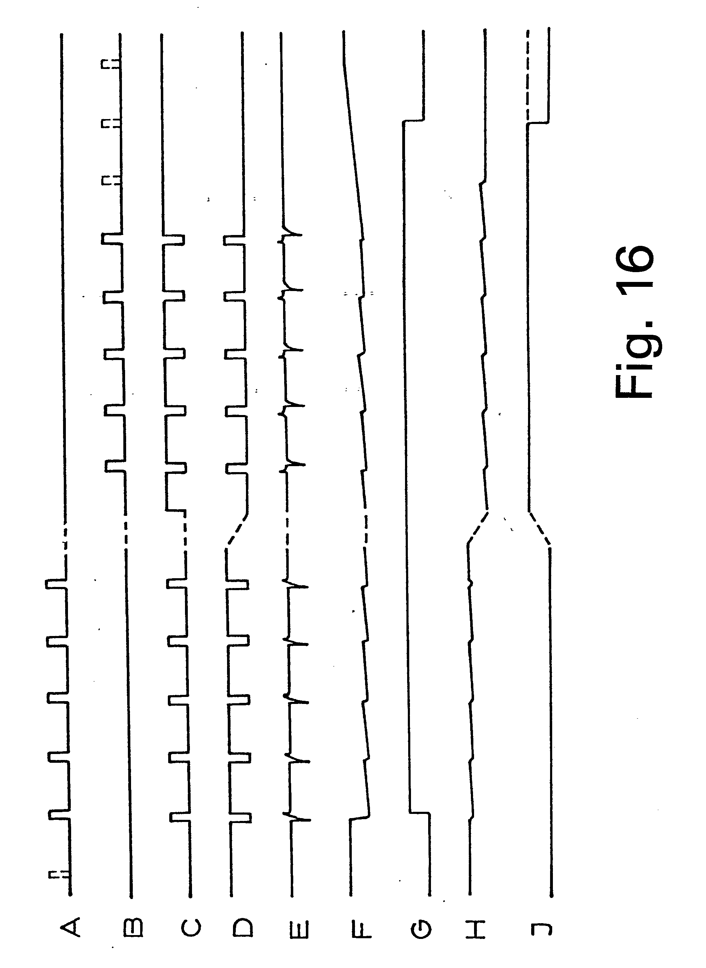

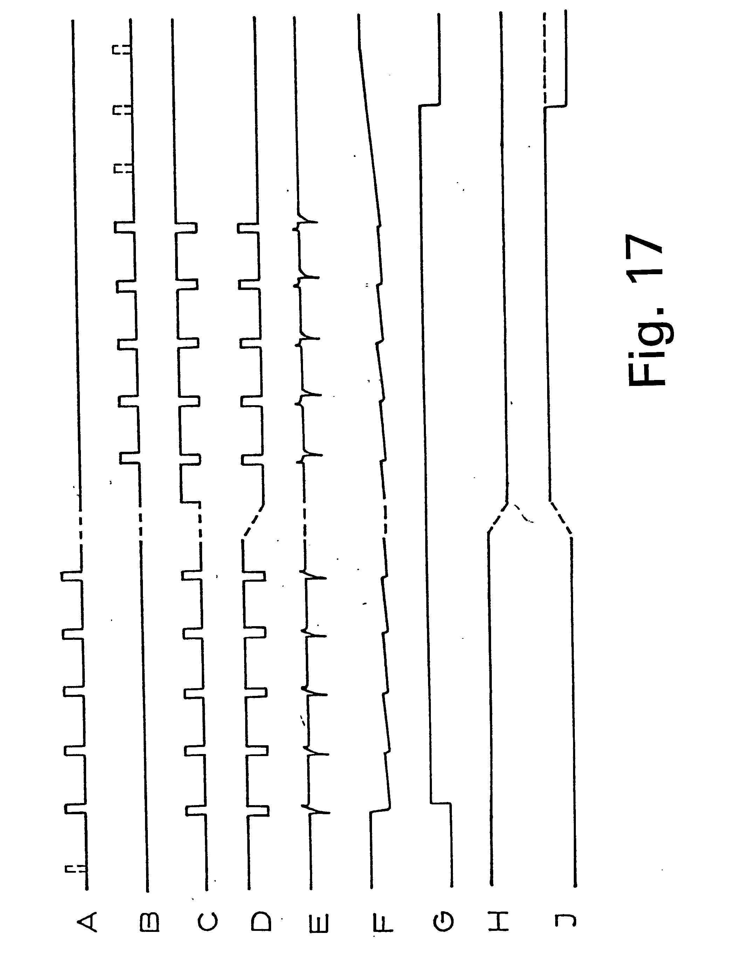

Die Fig. 16 und 17 zeigen die an den mit A. ......... bezeichneten Stellen auftretenden Impulse bzw. Signale.

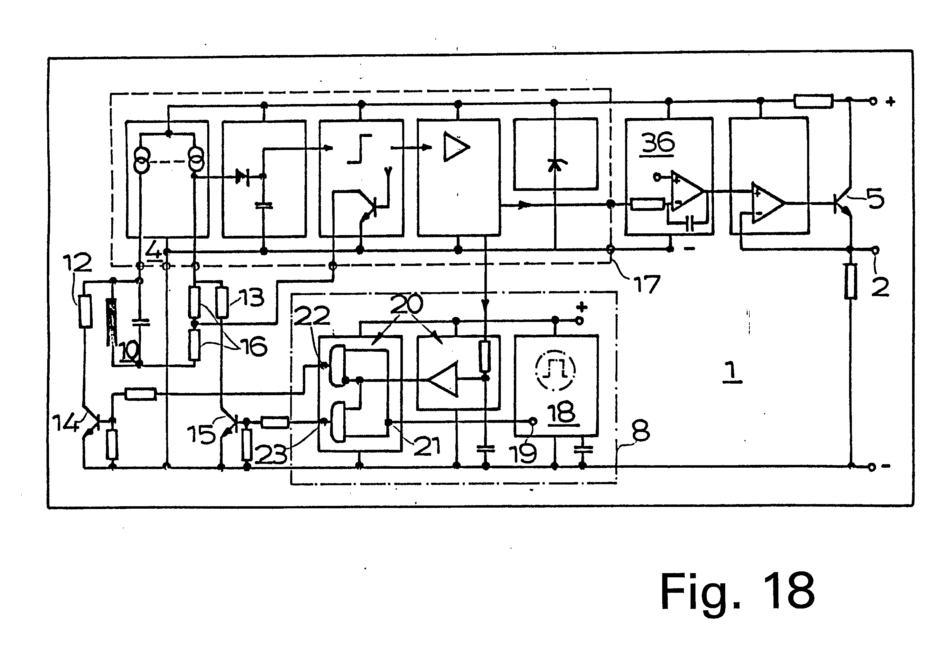

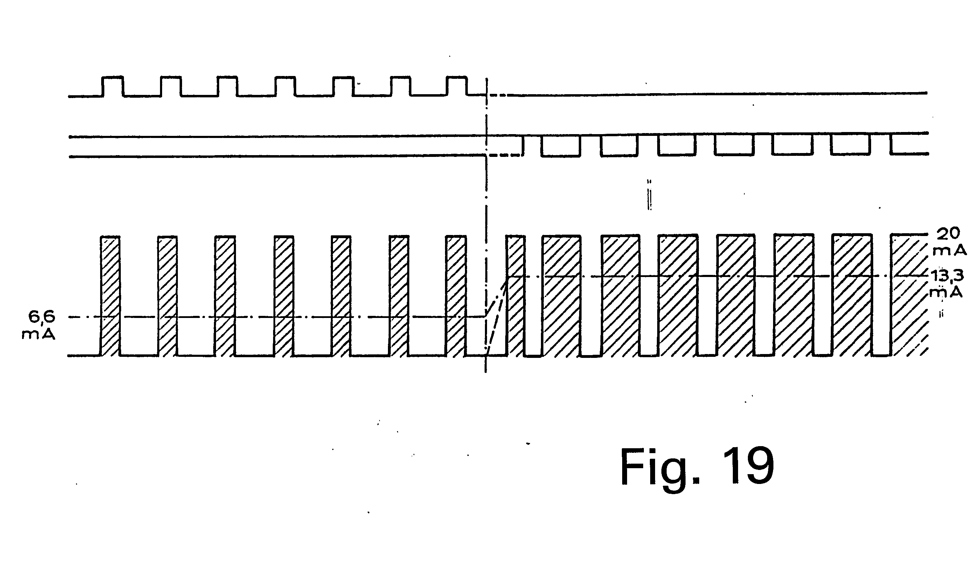

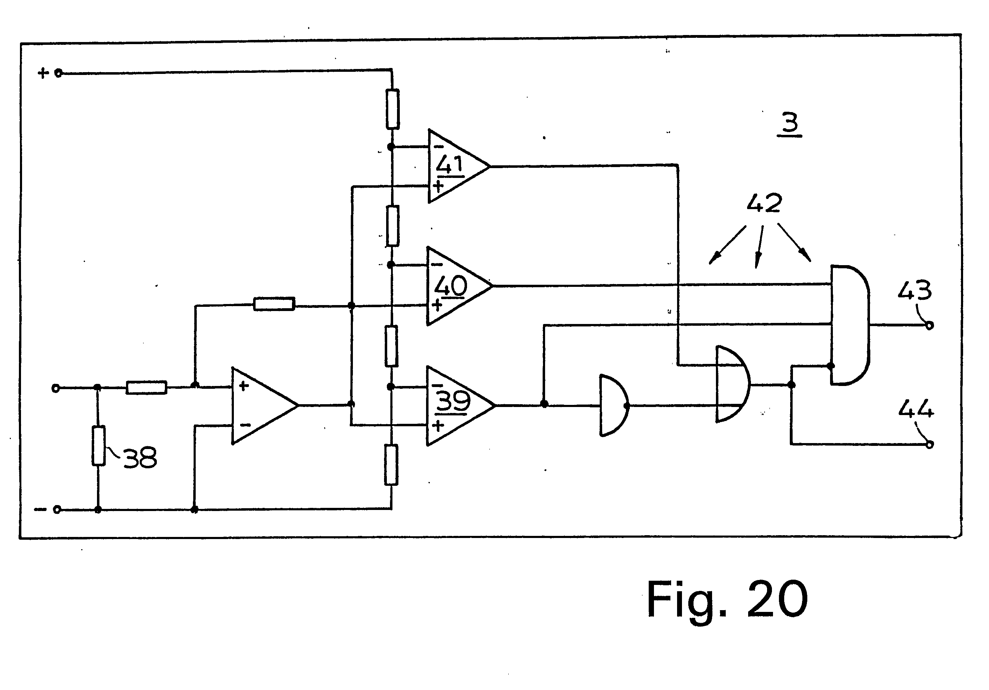

Die Fig. 18 bis 20 zeigen schliesslich ein weiteres Ausführungsbeispiel einer erfindungsgemässen Schaltungsanordnung, und zwar die Fig. 18 und 19 des zugehörigen elektronischen Schaltgerätes 1 und die Fig. 20 des zugehörigen Fehlerindikators 3.

Das in Fig. 18 dargestellte Ausführungsbeispiel eines elektronischen Schaltgerätes 1 entspricht zunächst weitgehend dem in Fig. 5 dargestellten Ausführungsbeispiel. Anstelle des in Fig. 5 dargestellten Ausführungsbeispiels des Überprüfungsimpulsgenerators 8 ist hier jedoch der in Fig. 6 dargestellte Überprüfungsimpulsgenerators 8 vorgesehen, wobei der zu dem Überprüfungsimpulsgenerator 8 gehörende Taktimpulsgenerator 18 vorzugsweise mit einem Tastverhältnis von 1 : 3 betrieben wird. Im übrigen weist im Ausführungsbeispiel nach Fig. 18 das elektronische Schaltgerät 1 noch eine analog arbeitende Integrierstufe 36 und einen Spannungs/Strom-Wandler 37 auf. Am Ausgang der analog arbeitenden Integrierstufe 36 stehen einmal ein Drittel und einmal zwei Drittel einer Referenzspannung $U_{ref}$ an. Mit Hilfe des Spannung/Strom-Wandlers 37 wird die Ausgangsspannung der analog arbeitenden Integrierstufe 36 in einen proportionalen Ausgangsstrom des Spannung/Strom-Wandlers 37 umgesetzt, wobei z.B. für hundert Prozent der Referenzspannung $U_{ref}$ ein Ausgangsstrom des Spannung/Strom-Wandlers 37 von 20 mA angesetzt werden kann. Dann erhält man dann, wenn das elektronische Schaltgerät 1 gesperrt ist, einen Ausgangsstrom von ca. 6,6 mA nominal und dann, wenn das elektronische Schaltgerät 1 leitend ist, einen Ausgangsstrom von ca. 13,3 mA nominal. Tritt nun ein Fehler auf, aus welchen Gründen auch immer, so wird der Ausgangsstrom zu 20 mA oder zu 0 mA tendieren, was als Fehler ausgewertet werden kann.

Mit Rücksicht auf in der Transmittertechnik häufig verwendete Signalpegel von 4 bis 20 mA (stromeingeprägt) können z.B. folgende Ausgangsströme am Spannung/Strom-Wandler 37 mit folgenden Bedeutungen gewertet werden:

a) Ausgangsstrom kleiner als 4 mA, elektronisches Schaltgerät 1 und/oder Aussenleiter 6 und/oder 7 fehlerbehaftet.

b) Ausgangsstrom zwischen 4 und 9,2 mA, elektronisches Schaltgerät 1 ausgeschaltet, elektronisches Schaltgerät 1 und Aussenleiter 6 und 7 fehlerfrei.

c) Ausgangsstrom zwischen 10,6 und 15,8 mA, elektronisches Schaltgerät 1 eingeschaltet, elektronisches Schaltgerät 1 und Aussenleiter 6 und 7 fehlerfrei.

d) Ausgangsstrom grösser als 16 mA, elektronisches Schaltgerät 1 und/oder Aussenleiter 6 und/oder 7 fehlerbehaftet.

Das, was zuvor dargelegt ist, kann besonders einfach in dem in Fig. 20 dargestellten Fehlerindikator 3 überwacht werden. Dieser Fehlerindikator 3 weist zunächst einen Messwiderstand 38 auf, der den Ausgangsstrom des Spannung/Strom-Wandlers 37 in eine proportionale Messspannung umsetzt. Diese Messspannung wird durch auf verschiedene Schwellen festgelegte Komparatoren 39, 40, 41 überwacht. Die von den Komparatoren 39, 40, 41 gelieferten Ausgangssignale werden in einer Überwachungslogik 42 derart verknüpft, dass am Überwachungsausgang 43 der Überwachungslogik 42 nur dann ein «tatsächliches» Ausgangssignal ansteht, wenn ein Fehler nicht vorliegt. Neben dem Überwachungsausgang 43 weist die Überwachungslogik 42 noch einen Fehlerausgang 44 auf, an der ein positives Fehlersignal ansteht, wenn ein Fehler vorliegt.

**Patentansprüche**

1. Schaltungsanordnung mit einem elektronischen, vorzugsweise berührungslos arbeitenden Schaltgerät (1) und einem an den Ausgang (2) des elektronischen Schaltgerätes (1) angeschlossenen Fehlerindikator (3), wobei das elektronische Schaltgerät (1) einen von aussen beeinflussbaren Anwesenheitsindikator, z.B. einen Oszillator (4), und einen von dem Anwesenheitsindikator steuerbaren elektronischen Schalter (5), z.B. einen Transistor, einen Thyristor oder einen Triac, aufweist und mit Hilfe des Fehlerindikators (3) feststellbar ist, ob das elektronische Schaltgerät (1) und/oder ein an das elektronische Schaltgerät (1) angeschlossener Aussenleiter (6, 7) einen Fehler aufweist, nämlich ein Überprüfungsimpulse (a) abgebender — interner oder externer — Überprüfungsimpulsgenerator (8) vorgesehen ist, das elektronische Schaltgerät (1) dann, wenn es keinen Fehler aufweist, an seinem Ausgang (2) eine ununterbrochene Folge von Überwachungsimpulsen (b) abgibt und der Fehlerindikator (3) dann und nur dann ein Fehlersignal abgibt, wenn am Fehlerindikator (3) keine ununterbrochene Folge von Überwachungsimpulsen (b) ankommt, dadurch gekennzeichnet, dass der Anwesenheitsindikator, z.B. ein Oszillator (4), zu Überprüfungs- bzw. Überwachungszwecken mit Hilfe der Überprüfungsimpulse (a) zyklisch sich wiederholend durch «künstliche» Bedämpfung oder Entdämpfung zur Abgabe von Steuerimpulsen anregbar ist und die Überwachungsimpulse am Ausgang (2) des elektronischen Schaltgerätes (1) durch die Steuerimpulse entstehen.

2. Schaltungsanordnung nach Anspruch 1, bei der der Anwesenheitsindikator des elektronischen Schaltgerätes (1) als Oszillator (4) ausgeführt ist, dadurch gekennzeichnet, dass der Oszillator (4) mit Hilfe der Überwachungsimpulse (a) bedämpfbar und/oder entdämpfbar ist.

3. Schaltungsanordnung nach Anspruch 2, bei der das elektronische Schaltgerät (1) als Schliesser ausgeführt ist, dadurch gekennzeichnet, dass der Oszillator (4) nur dann, wenn er von aussen unbedämpft ist, mit Hilfe der Überprüfungsimpulse (2) bedämpft und nur dann, wenn er von aussen bedämpft ist, mit Hilfe der Überprüfungsimpulse (a) entdämpft wird.

4. Schaltungsanordnung nach Anspruch 2, bei der das elektronische Schaltgerät (1) als Öffner ausgeführt ist, dadurch gekennzeichnet, dass der Oszillator (4) nur dann, wenn er von aussen bedämpft ist, mit Hilfe der Überprüfungsimpulse (a) entdämpft und nur dann, wenn er von aussen entdämpft ist, mit Hilfe der Überprüfungsimpulse (a) bedämpft wird.

5. Schaltungsanordnung nach Anspruch 2, bei der das elektronische Schaltgerät (1) als Schliesser ausgeführt ist, dadurch gekennzeichnet, dass der Oszillator (4) nur dann, wenn er von aussen bedämpft ist, mit Hilfe der Überprüfungsimpulse (a) entdämpft wird.

6. Schaltungsanordnung nach Anspruch 2, bei der das elektronische Schaltgerät (1) als Öffner ausgeführt ist, dadurch gekennzeichnet, dass der Oszillator (4) nur dann, wenn er von aussen unbedämpft ist, mit Hilfe der Überprüfungsimpulse (a) bedämpft wird.

7. Schaltungsanordnung nach einem der Ansprüche 2 bis 6, bei der der Oszillator (4) des elektronischen Schaltgerätes (1) einen in Emitterschaltung betriebenen Oszillatortransistor (9) aufweist sowie im Kollektorkreis des Oszillatortransistors (9) ein LC-Schwingkreis (10) und im Emitterkreis des Oszillatortransistors (9) ein Emitterwiderstand (11) vorgesehen sind, dadurch gekennzeichnet, dass dem LC-Schwingkreis (10) mit Hilfe von bedämpfenden Überprüfungsimpulsen (a) ein Bedämpfungswiderstand (12) und/oder dem Emitterwiderstand (11) mit Hilfe von entdämpfenden Überprüfungsimpulsen (a) ein Entdämpfungswiderstand (13) parallelschaltbar ist (Fig. 4).

8. Schaltungsanordnung nach einem der Ansprüche 2 bis 6, bei der der Oszillator (4) des elektronischen Schaltgerätes (1) einen einseitig an Masse liegenden LC-Schwingkreis (10) und ein ebenfalls einseitig an Masse liegendes Abgleich- und/oder Hysteresewiderstandsnetzwerk (16) aufweist, dadurch gekennzeichnet, dass dem LC-Schwingkreis (10) mit Hilfe von bedämpfenden Überprüfungsimpulsen (a) ein Bedämpfungswiderstand (12) und/oder dem Abgleich- und/oder Hysteresewiderstandsnetzwerk (16) mit Hilfe von entdämpfenden Überprüfungsimpulsen (a) ein Entdämpfungswiderstand (13) parallelschaltbar ist (Fig. 5).

## Claims

1. A circuit layout with an electronic switching equipment (1), preferably working without contact, and a fault indicator (3) connected to the output (2) of the electronic switching equipment (1) in which the electronic switching equipment (1) possesses a presence indicator e.g., an oscillator (4), susceptible to external influence, and an electronic switch (5) e.g. a transistor, a thyristor or a triac, and it can be determined by means of the fault indicator (3) whether the electronic switching equipment (1) and/or an external conductor (6, 7) attached to the electronic switching equipment (1) possesses a fault, that is to say an — internal or external — testing impulse generator (8), emitting testing impulses (a) is provided and the electronic switching equipment (1) if it does not posess a fault emits at its output (2) an uninterrupted succession of monitoring impulses (b), and the fault indicator (3) emits a fault signal when and only when no uninterrupted succession of monitoring impulses arrives at the fault indicator (3), characterised in that the presence indicator, e.g., an oscillator (4), can for the purposes of testing or monitoring by means of the testing impulses (a) repeatedly be cyclically stimulated to emit control impulses by «artificial» attenuation or de-attenuation and the monitoring impulses at the output (2) of the electronic switching equipment (1) result from the control impulses.

2. A circuit layout according to claim 1, in which the presence indicator of the electronic switching equipment (1) is constructed as an oscillator (4), characterised in that the oscillator (4) can be attenuated or de-attenuated by means of the testing impulses (a).

3. A circuit layout according to claim 2, in which the electronic switching equipment (1) is constructed as a closing switch, characterised in that the oscillator (5) is only attenuated by means of the testing impulses (a) if it is not externally attenuated, and is only de-attenuated by means of the testing impulses (a) if it is externally attenuated.

4. A circuit layout according to claim 2 in which the electronic switching equipment (1) is constructed as an opening switch, characterised in that the oscillator (4) is only de-attenuated by means of the testing impulses (a) if it is externally attenuated, and is only attenuated by means of the testing impulses (a) if it is externally de-attenuated.

5. A circuit layout according to claim 2 in which the electronic switching equipment (1) is constructed as a closing switch, characterised in that the oscillator (4) is only de-attenuated by means of the testing impulses (a) if it is externally attenuated.

6. A circuit layout according to claim 2 in which the electronic switching equipment (1) is constructed as an opening switch, characterised in that the oscillator (4) is only attenuated by means of the testing impulses (a) if it is externally de-attenuated.

7. A circuit layout according to one of claims 2 to 6 in which the oscillator (4) of the electronic switching equipment (1) possesses an oscillator transistor (9) driven in the emitter circuit, with an LC resonant circuit (10) provided in the collector circuit of the oscillator transistor (9) and an emitter resistance (11) provided in the emitter circuit of oscillator transistor (9), characterised in that by means of attenuating testing impulses (a) an attenuating resistance (12) can be switching in parallel with the LC resonant circuit and/or by means of de-attenuating testing impulses (a) a de-attenuating resistance (13) can be switched in parallel with the emitter resistance (11).

8. A circuit layout according to one of claims 2 to 6 in which the oscillator (4) of the electronic switching equipment possesses an LC resonant circuit (10) one side of which is connected to earth, and a balancing resistance network and/or hysteresis resistance network (16) one side of which is also connected to earth, characterised in that by means of attenuating testing impulses (a) an attenuating resistance (12) can be connected in parallel with the LC resonant circuit 10, and/or by means of de-attenuating testing impulses (a) a de-attenuating resistance (13) can be connected in parallel with the balancing resistance network and/or hysteresis resistance network (16).

## Revendications

1. Dispositif de connexion comportant un appareil de connexion électronique (1) fonctionnant de préférence sans contact et un indicateur de défauts (3) raccordé à la sortie (2) de l'appareil de connexion électronique (1) équipé d'un indicateur de présence influençable de l'extérieur, par exemple un oscillateur (4), et d'un contacteur électronique (5), par exemple un trasistor, un thyristor ou un triac, pouvant être commandé par l'indicateur de présence, ce dispositif de connexion devant permettre grâce à l'indicateur de défauts (3) d'indiquer si l'appareil de connexion électronique (1) et/ou un conducteur extérieur (6, 7) raccordé à l'appareil de connexion électronique (1) présente un défaut, dispositif dans lequel est prévu un générateur d'impulsions de contrôle (8) — interne ou externe — délivrant des impulsions de contrôle (b) et, lorsque l'appareil de connexion électronique (1) ne présente pas de défaut, celui-ci délivre à sa sortie (2) une série ininterrompue d'impulsions de surveillance (b) alors que l'indicateur de défauts (3) ne délivre un signal de défaut que lorsqu'aucune série ininterrompue d'impulsions de surveillance (b) ne parvient à l'indicateur de défauts (3), caractérisé en ce que l'indicateur de présence, par exemple un oscillateur (4), peut, en vue du contrôle ou de la surveillance, être excité de manière cyclique et répétée et grâce aux impulsions de contrôle (a) par un amortissement ou un désarmortissement «artificiels» pour délivrer des impulsions de commande et en ce que les impulsions de surveillance apparaissent à la sortie (2) de l'appareil de connexion électronique (1) sous l'action des impulsions de commande.

2. Dispositif de connexion selon la revendication 1 dans lequel l'indicateur de présence de l'appareil de connexion électronique (1) est exécuté sous la forme d'un oscillateur (4), caractérisé en ce que l'oscillateur (4) peut être amorti et/ou désamorti par les impulsions de contrôle (a).

3. Dispositif de connexion selon la revendication 2 dans lequel l'appareil de connexion électronique (1) est exécuté sous la forme d'un contact à fermeture, caractérisé en ce que l'oscillateur (4) n'est amorti par les impulsions de contrôle (a) que lorsqu'il n'est pas amorti de l'extérieur et qu'il n'est désamorti par les impulsions de contrôle (a) que lorsqu'il est amorti de l'extérieur.

4. Dispositif de connexion selon la revendication 2 dans lequel l'appareil de connexion électronique (1) est exécuté sous la forme d'un contact à ouverture, caractérisé en ce que l'oscillateur (4) n'est désamorti par les impulsions de contrôle (a) que lorsqu'il est amorti de l'extérieur et qu'il n'est amorti par les impulsions de contrôle (a) que lorsqu'il est désamorti de l'extérieur.

5. Dispositif de connexion selon la revendication 2 dans lequel l'appareil de connexion électronique (1) est exécuté sous la forme d'un contact à fermeture, caractérisé en ce que l'oscillateur (4) n'est désamorti par les impulsions de contrôle (a) que lorsqu'il est amorti de l'extérieur.

6. Dispositif de connexion selon la revendication 2 dans lequel l'appareil de connexion électronique (1) est exécuté sous la forme d'un contact à ouverture, caractérisé en ce que l'oscillateur (4) n'est amorti par les impulsions de contrôle (a) que lorsqu'il n'est pas amorti de l'extérieur.

7. Dispositif de connexion selon l'une des revendications 2 à 6 dans lequel l'oscillateur (4) de l'appareil de connexion électronique (1) possède un transistor d'oscillateur (9) actionné en montage émetteur ainsi qu'un circuit oscillant LC (10) dans le circuit collecteur du transistor de l'oscillateur (9) et une résistance d'émetteur (11) dans le circuit émetteur du transistor de l'oscillateur (9), caractérisé en ce qu'une résistance d'amortissement (12) peut être mise en parallèle avec le circuit oscillant LC (10) à l'aide d'impulsions de contrôle (a) amortissantes et/ou en ce qu'une résistance de désamortissement (13) peut être mise en parallèle avec la résistance d'émetteur (11) à l'aide d'impulsions de contrôle (a) désamortissantes.

8. Dispositif de connexion selon l'une des revendications 2 à 6 dans lequel l'oscillateur (4) de l'appareil de connexion électronique (1) possède un circuit oscillant LC (10) mis d'un côté à la masse et un réseau de résistances de compensation et/ou d'hystérésis (16) également mis d'un côté à la masse, caractérisé en ce qu'une résistance d'amortissement (12) peut être mise en parallèle avec le circuit oscillant LC (10) à l'aide d'impulsions de contrôle (a) amortissantes et/ou en ce qu'une résistance de désamortissement (13) peut être mise en parallèle avec le réseau de résistances de compensation et/ou d'hystérésis (16) à l'aide d'impulsions de contrôle (a) désamortissantes.

Fig. 1

# Fig. 2

elektronisches Schaltgerät
von außen

unbedämpft | bedämpft

# Fig. 3

elektronisches Schaltgerät
von außen

unbedämpft | bedämpft

# Fig. 4

Fig. 5

0 087 094

# Fig. 6

# Fig. 7

Fig. 8

0 087 094

Fig. 9

Fig. 10

Fig. 11

Fig. 12

0 087 094

Fig. 13

0 087 094

Fig. 14

Fig. 15

Fig. 16

Fig. 17

0 087 094

Fig. 18

0 087 094

Fig. 19

0 087 094

Fig. 20

0 087 094